(19) **Europäisches Patentamt / European Patent Office / Office européen des brevets**

(11) **EP 1 091 359 B1**

(12) **EUROPEAN PATENT SPECIFICATION**

(45) Date of publication and mention
of the grant of the patent:
**24.01.2007 Bulletin 2007/04**

(51) Int Cl.:
***G11C 16/06*** *(2006.01)*          ***G11C 16/28*** *(2006.01)*

(21) Application number: **00917428.5**

(22) Date of filing: **21.04.2000**

(86) International application number:
**PCT/JP2000/002653**

(87) International publication number:
**WO 2000/065601 (02.11.2000 Gazette 2000/44)**

(54) **NONVOLATILE SEMICONDUCTOR MEMORY**

NICHTFLUECHTIGER HALBLEITERSPEICHER

M MOIRE R MANENTE SEMICONDUCTEUR

(84) Designated Contracting States:
**AT BE CH CY DE DK ES FI FR GB GR IE IT LI LU MC NL PT SE**

(30) Priority: **23.04.1999 JP 11588799**
**13.04.2000 JP 2000111573**

(43) Date of publication of application:
**11.04.2001 Bulletin 2001/15**

(73) Proprietor: **MATSUSHITA ELECTRIC INDUSTRIAL CO., LTD.**
**Kadoma-shi, Osaka 571-8501 (JP)**

(72) Inventors:
• **MARUYAMA, Takafumi**
**Kadoma-shi, Osaka 571-0074 (JP)**
• **KOJIMA, Makoto**
**Suita-shi, Osaka 565-0804 (JP)**

(74) Representative: **Grünecker, Kinkeldey, Stockmair & Schwanhäusser**
**Anwaltssozietät**
**Maximilianstrasse 58**
**80538 München (DE)**

(56) References cited:
**EP-A- 0 618 589          EP-A- 0 638 906**
**US-A- 5 459 694          US-A- 5 822 248**

**Description**

**TECHNICAL FIELD**

The present invention relates to a nonvolatile semiconductor memory device and more particularly relates to a non-volatile semiconductor memory device constituting a flash memory device including a differential sense amplifier, for example.

**BACKGROUND ART**

In recent years, it has been proposed to apply a folded bit line arrangement, which is used for a dynamic random access memory (DRAM), for example, to a nonvolatile semiconductor memory device that is required to operate at higher and higher speeds. In the folded bit line arrangement, a bit line and a dummy bit line are connected in parallel to a sense amplifier. In this arrangement, a read operation is performed by comparing information on a memory cell connected to the bit line to reference information on a dummy cell connected to the dummy bit line and by amplifying its differential potential. The arrangements of this type are disclosed in Japanese Laid-Open Publication Nos. 6-290591 and 8-203291, for example.

These folded bit line arrangements are superior to conventional opened bit line arrangements in terms of noise immunity and low power dissipation, and therefore particularly effectively applicable to circuits that should operate at high speeds.

The present inventors analyzed a nonvolatile semiconductor memory device with the known folded bit line arrangement from various angles to find the following problems. Specifically, a device with the known folded bit line arrangement cannot read data from a memory cell accurately and rapidly enough, because there occurs capacitance unbalance between a bit line and a dummy bit line in reading out the data.

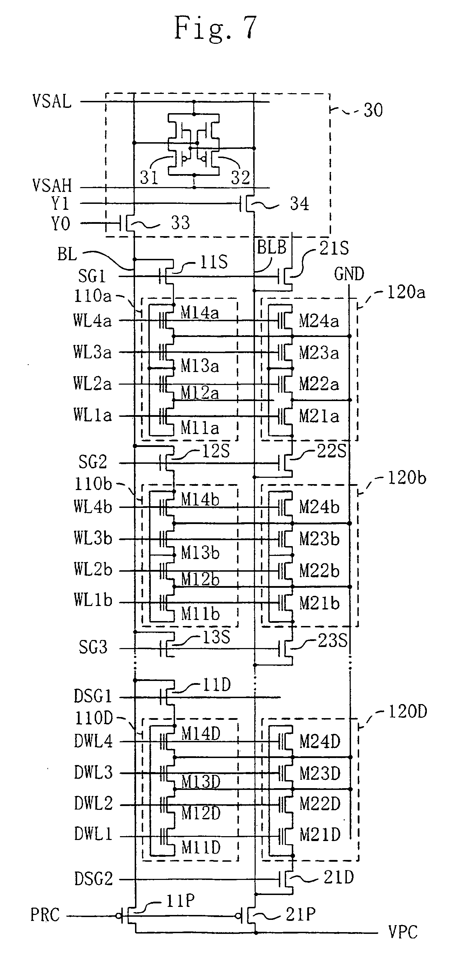

FIG. **7** illustrates a circuit configuration for a non-volatile semiconductor memory device with the folded bit line arrangement as disclosed in Japanese Laid-Open Publication No. 8-203291. As shown in FIG. **7**, the device includes: a sense amplifier **30**; a bit line **BL**, one end of which is connected to the sense amplifier **30** via a transfer gate **33** and the other end of which is connected to a pre-charging transfer gate **11P**; and a complementary bit line **BLB**, one end of which is connected to the sense amplifier **30** via a transfer gate **34** and the other end of which is connected to a pre-charging transfer gate **21P**. First and second memory cell blocks **110a** and **120a** are connected to the bit line **BL** and complementary bit line **BLB** by way of first and second select gates **11S** and **22S**, respectively.

The first memory cell block **110a** consists of four memory cells **M11a** through **M14a**, which are connected in series together and also connected to word lines **WL1a** through **WL4a**, respectively. The second memory cell block **120a** consists of four memory cells **M21a** through **M24a**, which are connected in series together and also connected to the word lines **WL1a** through **WL4a**, respectively. Third and fourth memory cell blocks **110b** and **120b** with the same configurations as the first and second memory cell blocks **110a** and **120a** are connected to the bit line **BL** and complementary bit line **BLB** via third and fourth select gates **12S** and **23S**, respectively.

Furthermore, a first dummy cell block **110D** with the same configuration as the first memory cell block **110a** is connected to the bit line **BL** via a first dummy select gate **11D**. And a second dummy cell block **120D** with the same configuration as the first dummy cell block **110D** is connected to the complementary bit line **BLB** via a second dummy select gate **21D**.

Hereinafter, it will be briefly described how the non-volatile semiconductor memory device with such an arrangement performs a read operation.

For example, suppose information stored on the memory cell **M14b** in the third memory cell block **110b** should be read out from the memory cell **M14b** among the multiple memory cells. Then, reference information (i.e., a reference potential) is supplied from the dummy cells **M21D** and **M22D** to the sense amplifier **30**. In this case, information is now being written on the memory cell **M14b**, i.e., the threshold voltage of the memory cell is between 1 and 2 V and the drain-source current thereof is about 80 $\mu$A. It should be noted that a memory cell is erased when a threshold voltage thereof is 8 V or more and the drain-source current thereof is 0$\mu$A. On the other hand, the reference information on the dummy cells **M21D** and so on is supposed to be average between a memory cell being erased and a memory cell being written.

First, the bit line **BL** and complementary bit line **BLB** are pre-charged to a potential, which may be half of a supply potential **VDD**, by way of the pre-charging transfer gates **11P** and **21P**, respectively. Thereafter, the word line **WL4b**, connected to the control gate of the memory cell **M14b**, is activated and a select signal **SG2**, applied to the gate of the third select gate **12S**, is asserted to turn the third select gate **12S** ON. In this manner, the information on the memory cell **14b** is transferred to the bit line **BL**. In this case, a capacitive component of the third memory cell block **110b** is applied to the bit line **BL**. At the same time, since the select signal **SG2** also turns the second select gate **22S** ON, a capacitive component of the second memory cell block **120a** is applied to the complementary bit line **BLB**.

On the other hand, the dummy cells **M21D** and **M22D** generate the reference potential to identify the information on the memory cell **M14b**. In this case, dummy word lines **DWL1** and **DWL2** connected to the respective control gates of the dummy cells **M21D** and **M22D** are activated and a dummy select signal **DSG2**, applied to the gate of the second dummy select gate **21D**, is asserted to turn the second dummy select gate **21D** ON. In this manner, the reference information is transferred from the dummy cells **M21D** and **M22D** to the complementary bit line **BLB**. In this case, a capacitive component of the second dummy cell block **120D** is applied to the complementary bit line **BLB** by way of the second dummy select gate **21D**.

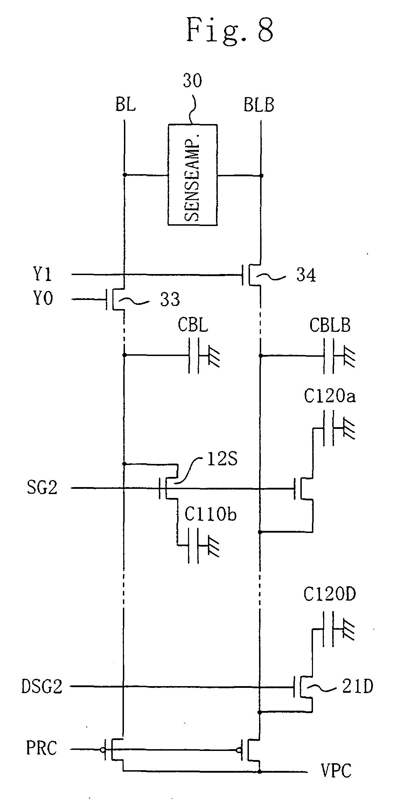

FIG. **8** schematically illustrates respective capacitive components applied to the bit line **BL** and complementary bit line **BLB** while the semiconductor memory device shown in FIG. **7** performs reading. In FIG. **8**, the same members as those illustrated in FIG. **7** are identified by the same reference numerals. As shown in FIG. **8**, when a memory cell connected to the bit line **BL** is accessed, the sense amplifier **30** senses the line and diffusion capacitive components **CBL** of the bit line **BL** and the capacitive component **C110b** of the third memory cell block **110b** from the bit line **BL**. The sense amplifier **30** also senses the line and diffusion capacitive components **CBLB** of the complementary bit line **BLB,** the capacitive component **C120a** of the second memory cell block **120a** and the capacitive component **C120D** of the second dummy cell block **120D** from the complementary bit line **BLB**. In this case, the capacitive component **C110b** or **C120D** includes the diffusion capacitances of respective cells and the line capacitance of a sub-bit line when the drain of each cell is connected to the select gate.

As can be seen from FIG. **8**, the capacitive component applied to the bit line **BL** is different from that applied to the complementary bit line **BLB** during reading. For example, supposing each of the second and third memory cell blocks **120a** and **110b** and second dummy cell block **120D** consists of the same number of memory cells, the capacitive component **CBL** of the bit line **BL** is not greatly different from the capacitive component **CBLB** of the complementary bit line **BLB**. Thus, extra capacitive load, i.e., the capacitive component **C120D** of the dummy cell block **120D**, is applied to the complementary bit line **BLB** and seriously affects a read time.

In performing a read operation using the differential sense amplifier **30**, the charges stored on the bit line **BL** and complementary bit line **BLB** are drained with cell current flowing through the memory cell **14b** and the cell currents flowing through the dummy cells **M21D** and **M22D**, respectively. As a result, a potential difference is created between the bit line **BL** and complementary bit line **BLB** and then amplified.

In this case, a potential variation on the complementary bit line **BLB**, to which the dummy cells **M21D** and **M22D** are connected, is preferably a median between a potential variation on the bit line **BL**, to which a memory cell being erased is connected, and a potential variation on the bit line **BL**, to which a memory cell being written is connected. For example, suppose a constant cell current flows through the memory cell **M14b** and a current flowing through the dummy cells **M21D** and **M22D** is half of the cell current of the memory cell **M14b**. And also suppose the capacitive loads of the bit line **BL** and complementary bit line **BLB** are equal to each other. In that case, a potential variation $\Delta$**V** after a predetermined time $\Delta$**t** has passed since the start of discharge is given by the following Equation (1) by modifying a relationship I=C(dV/dt):

$$\Delta V = (\Delta t/C) \cdot I \qquad\qquad (1)$$

where V, I, C and t represent voltage, current, capacitance and time, respectively.

As can be seen from Equation (1), the potential variation $\Delta$**v** is inversely proportional to the capacitance **C** and the variation $\Delta$**t** with time is proportional to the capacitance **C**. As also can be seen from this relation, if the additional capacitive load **C120D** is applied to the complementary bit line **BLB**, then it takes a longer time to cause the predetermined potential variation on the complementary bit line **BLB**, and an extra read time is needed.

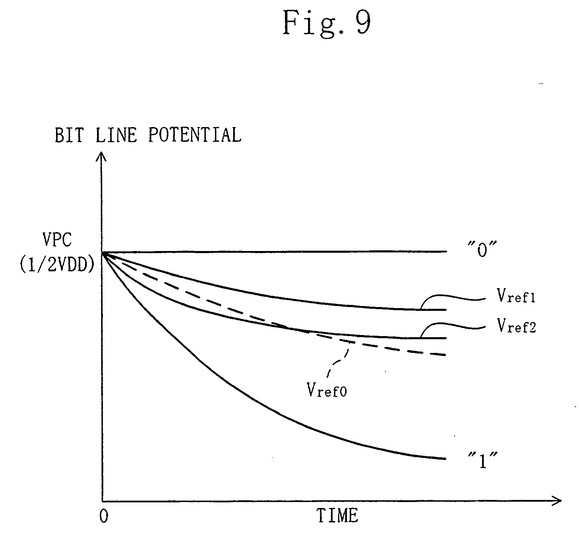

FIG. **9** illustrates discharge waveforms of the circuit shown in FIG. **8**. In FIG. **9**, the abscissa represents time, while the ordinate represents potentials on the bit line **BL**. **VPC** represents a pre-charge potential, i.e., 1/2 VDD. As shown in FIG. **9**, since a predetermined drain-source current flows through a memory cell being written as indicated by "1", its potential decreases with time. In contrast, since no drain-source current flows through a memory cell being erased as indicated by "0", its potential does not decrease with time. In FIG. **9**, the reference potentials **Vref** represent the waveforms of discharge where the dummy cells **M21D** and **M22D** are connected to the complementary bit line **BLB**. Specifically, **Vref0** represents an ideal state, **Vref1** represents a situation where the capacitive load **C120D** is large and **Vref2** represents a situation where the capacitive load **C120D** is small. As can be seen from these results, if the capacitive load **C120D** is added, the waveform of discharge of the complementary bit line **BLB** deviates from the ideal waveform **Vref0** of discharge. This is because a capacitance unbalance occurs between the bit line **BL** and complementary bit line **BLB**. In such a situation, the ideal reference potential **Vref0** cannot be generated, and it takes an additional time to attain the predetermined potential difference required for reading. As a result, high-speed reading is interfered with.

From EP 0 638 906 a non-volatile semiconductor memory is known.

## DISCLOSURE OF INVENTION

An object of the present invention to enable a nonvolatile semiconductor memory device to perform a read operation much more accurately and rapidly and thereby solve the problems of the prior art.

To achieve this object, a dummy cell is provided for each memory cell block in the inventive nonvolatile semiconductor memory device, thereby eliminating the capacitance unbalance between bit line and complementary bit line during data reading. In addition, memory cell blocks connected to the bit and complementary bit lines are activated responsive to mutually different control signals.

Specifically, an inventive nonvolatile semiconductor memory device includes: first and second word lines; first and second bit lines, each intersecting with both of the first and second word lines; first and second memory cell blocks, each including at least one memory cell connected to the first word line; third and fourth memory cell blocks, each including at least one memory cell connected to the second word line; first connection means for connecting the first bit line to the first memory cell block responsive to a first control signal; second connection means for connecting the second bit line to the second memory cell block responsive to a second control signal; third connection means for connecting the first bit line to the third memory cell block responsive to a third control signal; fourth connection means for connecting the second bit line to the fourth memory cell block responsive to a fourth control signal; and an amplifier for performing input/output operations on the first and second bit lines. Each said memory cell block includes at least one dummy cell.

In the inventive nonvolatile semiconductor memory device, at least one dummy cell is provided for each of the first and third memory cell blocks that are connected to the first bit line and the second and fourth memory cell blocks that are connected to the second bit line. And each of the memory cell blocks, which is connected to the first or second bit line, has the same configuration. Accordingly, almost equal capacitive loads are sensed by the amplifier for the first and second bit lines. In addition, the first through fourth memory cell blocks are connected by way of the first through fourth connection means operating in response to the first through fourth control signals, respectively. Thus, a pseudo-folded bit line arrangement, which is similar to, but different from, the folded bit line arrangement, can be adopted for the amplifier, thereby reducing noise components affecting the first and second bit lines. As a result, the sensitivity of the amplifier can be increased and the read time can be shortened.

In the inventive nonvolatile semiconductor memory device, the memory cell blocks are preferably provided to have an equal capacitance. In such an embodiment, the capacitive loads of the first and second bit lines, which are sensed by the amplifier, can be equalized just as designed.

In the inventive nonvolatile semiconductor memory device, a capacitive load, which is added to the amplifier by the first bit line and the first or third memory cell block, is preferably substantially equal to a capacitive load, which is added to the amplifier by the second bit line and the second or fourth memory cell block.

In the inventive nonvolatile semiconductor memory device, in reading out data from one of the memory cells connected to the first bit line to the amplifier, one of the dummy cells, which is included in one of the memory cell blocks that is located near the memory cell block including the memory cell being accessed and that is connected to the second bit line, is preferably selected. In such an embodiment, the dummy cell selected is located relatively near the memory cell being accessed, and therefore a signal delay or the superposition of noise on the second bit line can be reduced. As a result, a read operation can be performed much more rapidly and accurately.

In the inventive nonvolatile semiconductor memory device, in reading out data from one of the memory cells connected to the first bit line to the amplifier by activating the first or second word line, one of the dummy cells, which is included in one of the memory cell blocks that is connected to one of the word lines, to which the memory cell being accessed is not connected, and to the second bit line, is preferably selected. In such an embodiment, the dummy cell for supplying a reference potential for the memory cell being accessed to the amplifier can be selected from a memory cell block located near the memory cell block including the memory cell being accessed. Thus, the dummy cell selected can be relatively close to the memory cell being accessed, and therefore a signal delay or the superposition of noise on the second bit line can be reduced. As a result, a read operation can be performed much more rapidly and accurately.

The inventive nonvolatile semiconductor memory device may further include multiple cell array units, each including the first, second and third and fourth memory cell blocks. In reading out data from one of the memory cells connected to the first bit line in one of the cell array units to the amplifier by activating the first or second word line, one of the dummy cells, which is included in one of the memory cell blocks that is connected to one of the word lines, to which the memory cell being accessed is not connected, and to the second bit line in the cell array unit, is preferably selected. In such an embodiment, even if there are multiple cell array units, each including the first through fourth memory cell blocks, the dummy cell, which supplies a reference potential for the memory cell being accessed to the amplifier, can be selected correctly from a memory cell block located near the memory cell block including the memory cell being accessed.

In this case, each said memory cell block preferably includes multiple dummy cells. And when one of the dummy cells is selected, a wire length between the dummy cell selected and the second bit line is preferably substantially equal to a wire length between the first bit line and the memory cell being accessed and connected to the first bit line.

Also, in this case, each said memory cell block preferably includes multiple dummy cells. And one of the dummy cells, which is located closest to the memory cell being accessed and connected to the first bit line, is preferably selected.

In the inventive nonvolatile semiconductor memory device, each said memory cell block preferably includes: a first dummy cell connected to an odd-numbered one of the word lines; and a second dummy cell connected to an even-numbered one of the word lines. The first dummy cell is preferably selected in selecting one of the memory cells connected to an odd-numbered one of the word lines, while the second dummy cell is preferably selected in selecting one of the memory cells connected to an even-numbered one of the word lines. In such an embodiment, even if memory cells connected to an even-numbered word line have characteristics different from those of memory cells connected to an odd-numbered word line due to process conditions, for example, those dummy cells can be provided for the even- or odd-numbered word line. Thus, the electrical characteristics of a memory cell can be matched to those of a dummy cell. In other words, each dummy cell can generate a reference potential in accordance with the characteristics of the associated memory cell. That is to say, the reference potential can be generated more precisely during reading. As a result, the sensitivity of the amplifier can be improved and the read time can be shortened.

In the inventive nonvolatile semiconductor memory device, the dummy cells are preferably located around respective ends of the memory cell blocks so as to face each other in a direction in which the bit lines extend. In such an embodiment, the wire length between each selected memory cell and the amplifier by way of its bit line is not so much different from the wire length between associated dummy cell selected and the amplifier by way of its bit line. Thus, neither signal delay nor superposition of noise is likely to occur. Furthermore, it becomes much easier to use the same signal as the first and fourth control signals or as the second and third control signals. As a result, the area of the signal lines can be reduced and the circuit configuration can be simplified.

In the inventive nonvolatile semiconductor memory device, the first control signal is preferably the same as the fourth control signal and the second control signal is preferably the same as the third control signal. In such an embodiment, generation of the first and fourth control signals or the second and third control signals can be easily synchronized with each other. That is to say, it is much easier to synchronize the control signals.

## BRIEF DESCRIPTION OF DRAWINGS

FIG. **1** is a schematic representation illustrating arrangement and operating principle of the inventive nonvolatile semiconductor memory device.

FIG. **2** is a circuit diagram illustrating a nonvolatile semiconductor memory device according to a first embodiment of the present invention.

FIG. **3** is a timing diagram illustrating an exemplary operation of the nonvolatile semiconductor memory device according to the first embodiment of the present invention.

FIG. **4** is a circuit diagram illustrating a nonvolatile semiconductor memory device according to a second embodiment of the present invention.

FIG. **5** is a circuit diagram illustrating a cell array in the nonvolatile semiconductor memory device according to the second embodiment of the present invention.

FIG. **6** is a timing diagram illustrating an exemplary operation of the nonvolatile semiconductor memory device according to the second embodiment of the present invention.

FIG. **7** is a circuit diagram illustrating a known non-volatile semiconductor memory device with a folded bit line arrangement.

FIG. **8** is a schematic representation illustrating capacitive load components in the known nonvolatile semiconductor memory device.

FIG. **9** is a graph illustrating waveforms of discharge in the conventional folded bit line arrangement.

## BEST MODE FOR CARRYING OUT THE INVENTION

First, a basic idea of the nonvolatile semiconductor memory device of the present invention will be described. A well-known memory cell for a nonvolatile semiconductor memory device includes a floating gate between a substrate and a control gate. The memory cell stores information thereon digitally depending on whether or not electrons are retained on the floating gate. Specifically, where electrons are retained on the floating gate, the threshold value of a gate voltage applied to the control gate is relatively high, and therefore substantially no current flows through the memory cell even if a predetermined gate voltage is applied thereto. In such a state, "0" is being stored. Conversely, where no electrons are retained thereon, the threshold value of the gate voltage is relatively low, and therefore current does flow through the memory cell if the predetermined gate voltage is applied to the control gate. In such a state, "1" is being stored. The state where no electrons are retained is herein regarded as being written, or "1", while the state where electrons are retained is herein regarded as being erased, or "0".

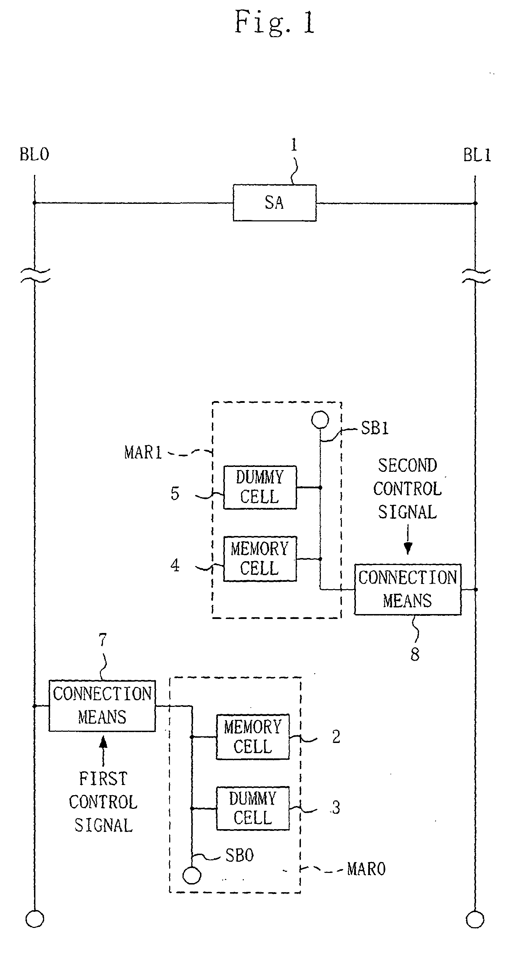

FIG. **1** illustrates a schematic block arrangement showing the operating principle of the inventive nonvolatile semiconductor memory device. As shown in FIG. **1**, the nonvolatile semiconductor memory device includes: a sense amplifier **1**; a main bit line **BL0** connected to the sense amplifier **1**; a complementary main bit line **BL1**, which is also connected to the sense amplifier **1** and has a potential complementary to that of the main bit line **BL0** while the sense amplifier **1** is operating; a first memory cell block **MAR0**, which includes at least one memory cell **2** and at least one dummy cell **3** that are connected in parallel to a first sub-bit line **SB0**; and a second memory cell block **MAR1**, which includes at least one memory cell **4** and at least one dummy cell **5** that are connected in parallel to a second sub-bit line **SB1**.

The first memory cell block **MAR0** is connected to the main bit line **BL0** via first connection means **7** receiving a first control signal. On the other hand, the second memory cell block **MAR1** is connected to the complementary main bit line **BL1** via second connection means **8** receiving a second control signal. Although not shown, control lines are provided for the sense amplifier **1**, memory cells **2** and **4** and dummy cells **3** and **5** to control them independently.

In the inventive nonvolatile semiconductor memory device, the dummy cell **3** or **5** is provided for each memory cell block **MAR0** or **MAR1**. Thus, while data is being read out from the memory cell **2** or **4**, the sense amplifier **1** senses a substantially equal capacitive load from the main bit line **BL0** and complementary main bit line **BL1**. For that reason, the unbalance in capacitance component between the main bit line **BL0** and complementary main bit line **BL1**, which is caused when the dummy cells **3** and **5** are provided outside of the memory cell blocks **MAR0** and **MAR1**, can be eliminated.

In this example, a folded bit line arrangement with excellent noise immunity is illustrated. Alternatively, the same effects are attainable even if an opened bit line arrangement is used instead.


EMBODIMENT 1

Hereinafter, a first embodiment of the present invention will be described with reference to the drawings.

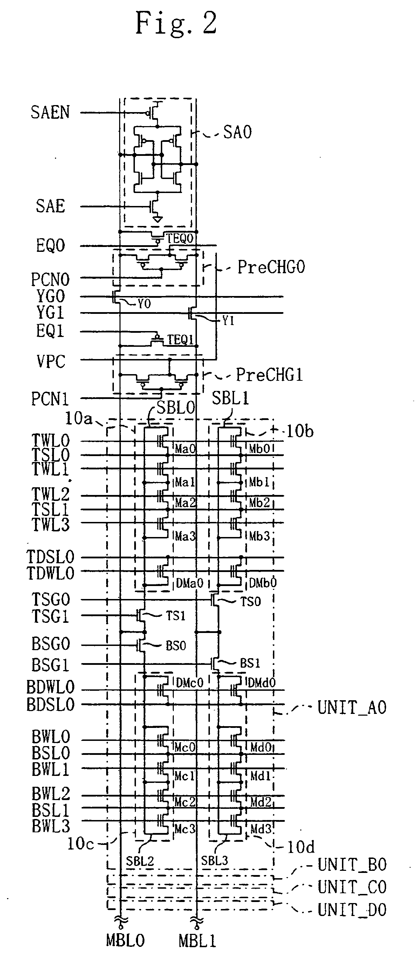

FIG. **2** illustrates a circuit configuration for a non-volatile semiconductor memory device according to the first embodiment of the present invention. In FIG. **2**, only memory cell blocks **10a** through **10d**, connected to a single sense amplifier **SA0**, are illustrated. Actually, though, a great number of sense amplifiers **SA0** are provided for the same number of columns. As shown in FIG. **2**, the device includes: a main bit line **MBL0** (i.e., first bit line), one end of which is connected to the sense amplifier **SA0** via a first column gate **Y0**; and a complementary main bit line **MBL1** (i.e., second bit line), one end of which is connected to the sense amplifier **SA0** via a second column gate **Y1** in parallel to the main bit line **MBL0**. In this case, the first and second column gates **Y0** and **Y1** receive first and second column gate control signals **YG0** and **YG1** at their gates, respectively.

The first memory cell block **10a** is connected to the main bit line **MBL0** by way of a first select gate (i.e., first connection means) **TS1** receiving a first select signal (i.e., first control signal) **TSG1**. On the other hand, the second memory cell block **10b** is connected to the complementary main bit line **MBL1** by way of a second select gate (i.e., second connection means) **TS0** receiving a second select signal (i.e., second control signal) **TSG0**.

In the same way, the third memory cell block **10c** is connected to the main bit line **MBL0** by way of a third select gate (i.e., third connection means) **BS0** receiving a third select signal (i.e., third control signal) **BSG0**. The fourth memory cell block **10d** is connected to the complementary main bit line **MBL1** by way of a fourth select gate (i.e., fourth connection means) **BS1** receiving a fourth select signal (i.e., fourth control signal) **BSG1**.

In this manner, a first cell array unit **UNIT_A0** is made up of these first through fourth memory cell blocks **10a** through **10d**. Although not illustrated, other cell array units **UNIT_B0** through **UNIT_D0** with the same configuration as the first cell array unit **UNIT_A0** are further provided according to this embodiment.

The first memory cell block **10a** consists of: four memory cells **Ma0** through **Ma3**, which are connected in series together and to word lines **TWL0** through **TWL3**, respectively; and a dummy cell **DMa0** connected to a dummy word line **TDWL0.** The drains of these memory cells **Ma0** through **Ma3** are connected to the first select gate **TS1** through a sub-bit line **SBL0**, while the sources thereof are connected to source lines **TSL0** and **TSL1**. The drain of the dummy cell **DMa0** is also connected to the first select gate **TS1**, while the source thereof is connected to a dummy source line **TDSL0**.

The second memory cell block **10b** consists of: four memory cells **Mb0** through **Mb3**, which are connected in series together and to the word lines **TWL0** through **TWL3**, respectively; and a dummy cell **DMb0** connected to the dummy word line **TDWL0**. The drains of these memory cells **Mb0** through **Mb3** are connected to the second select gate **TS0** through a sub-bit line **SBL1**, while the sources thereof are connected to the source lines **TSL0** and **TSL1**. The drain of the dummy cell **DMb0** is also connected to the second select gate **TS0**, while the source thereof is connected to the dummy source line **TDSL0**.

The third and fourth memory cell blocks **10c** and **10d**, which are connected to the main and complementary main bit lines **MBL0** and **MBL1,** have the same configuration as the first and second memory cell blocks **10a** and **10b**, respectively. Thus, only dummy cells **DMc0** and **DMd0** included in the third and fourth memory cell blocks **10c** and **10d** will be described.

The dummy cell **DMc0** included in the third memory cell block **10c** is connected to a dummy word line **BDWL0**. The drain thereof is connected to the third select gate **BS0**, while the source thereof is connected to a dummy source line **BDSL0**.

The dummy cell **DMd0** included in the fourth memory cell block **10d** is also connected to the dummy word line **BDWL0**. The drain thereof is connected to the fourth select gate **BS1**, while the source thereof is connected to the dummy source line **BDSL0**.

The sense amplifier **SA0** is an amplifier of a flip-flop type including two CMOS inverters, in which the input terminal of one of these two inverters is cross-coupled to the output terminal of the other, and vice versa. Also, the sense amplifier **SA0** is controlled responsive to a sense amplifier enable signal **SAE** and its inverted signal **SAEN**. In this example, the sense amplifier **SA0** is enabled when the signals **SAE** and **SAEN** are at high and low levels, respectively.

A first pre-charge circuit **PreCHG0** including two p-channel MOS transistors for applying a pre-charge voltage to the main and complementary main bit lines **MBL0** and **MBL1**; and a first equalize transistor **TEQ0** receiving a first equalize signal **EQ0** at its gate and eliminating the potential difference between the main and complementary main bit lines **MBL0** and **MBL1** are provided between the sense amplifier **SA0** and the first and second column gates **Y0** and **Y1** for the main and complementary main bit lines **MBL0** and **MBL1**.

A second pre-charge circuit **PreCHG1** including two p-channel MOS transistors for applying a pre-charge voltage to the main and complementary main bit lines **MBL0** and **MBL1**; and a second equalize transistor **TEQ1** receiving a second equalize signal **EQ1** at its gate and eliminating the potential difference between the main and complementary main bit lines **MBL0** and **MBL1** are further provided between the first and second column gates **Y0** and **Y1** and the first cell array unit **UNIT_A0** for the main and complementary main bit lines **MBL0** and **MBL1**.

The first and second pre-charge circuits **PreCHG0** and **PreCHG1** are controlled in response to first and second pre-charge signals **PCN0** and **PCN1**, respectively. While the first or second pre-charge circuit **PreCHG0** or **PreCHG1** is being enabled, a pre-charge voltage of the pre-charge signal **VPC**, e.g., a voltage half of the supply voltage **VDD** (=1/2 VDD), is supplied to the main and complementary main bit lines **MBL0** and **MBL1**.

Hereinafter, it will be described with reference to the timing chart how the nonvolatile semiconductor memory device with such an arrangement operates.

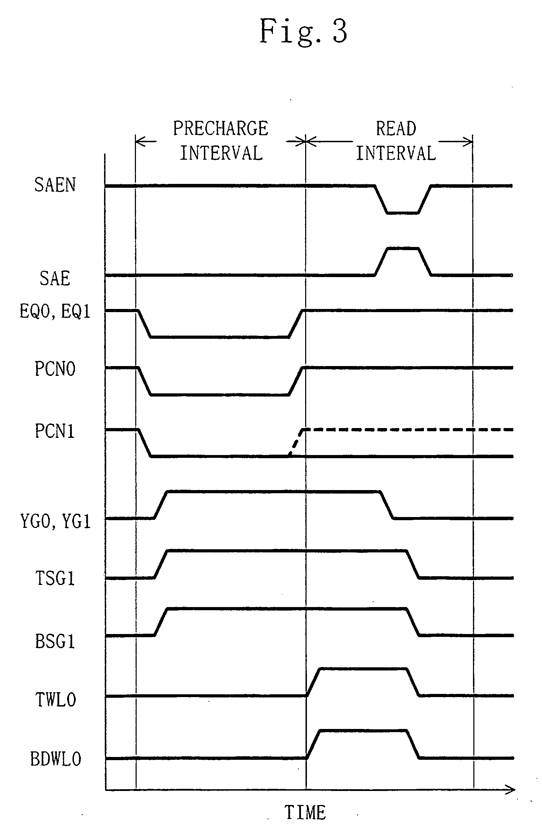

FIG. **3** illustrates a timing chart showing a read operation performed by the nonvolatile semiconductor memory device according to this embodiment. In this example of operation, data is read out from the memory cell **Ma0** in the first memory cell block **10a** connected to the main bit line **MBL0** as shown in FIG. **2**. In a standby state in which no read or write operation is being performed, the potentials on the sub-bit lines **SBL0** through **SBL3** connected to the main or complementary main bit line **MBL0** or **MBL1** are kept at the ground level by reset transistors (not shown). Also, even during a read operation, potentials on the source lines **TSL0**, **TSL1**, **BSL0**, **BSL1**, **TDSL0** and **BDSL0** are kept at the ground level.

First, when a READ instruction is externally input, a pre-charge interval shown in FIG. **3** starts, when the first and second pre-charge signals **PCN0** and **PCN1** are changed from the high into low level with the word lines **TWL0** through **TWL3** and **BWL0** through **BWL3**, dummy word lines **TDWL0** and **BDWL0** and first through fourth select signals **TSG1, TSG0, BSG0** and **BSG1** shown in FIG. **2** all kept deactivated (i.e., low). As a result, the first and second pre-charge circuits **PreCHG0** and **PreCHG1** are turned ON to raise the potentials on the main and complementary main bit lines **MBL0** and **MBL1** to the pre-charge voltage of 1/2 VDD. At the same time, the first and second equalize signals **EQ0** and **EQ1** are also changed into the low level, thereby turning the first and second equalize transistors **TEQ0** and **TEG1** ON and connecting the main and complementary main bit lines **MBL0** and **MBL1** together. In this manner, the potential difference between the main and complementary main bit lines **MBL0** and **MBL1** is eliminated.

Next, the first and second column gate control signals **YG0** and **YG1**, connecting the main and complementary main bit lines **MBL0** and **MBL1** to the sense amplifier **SA0**, respectively, are changed into the high level to turn the column gates **Y0** and **Y1** ON. In this manner, the input and output terminals of the sense amplifier **SA0** are also pre-charged to the same potential level as the main bit line **MBL0**. By providing this pre-charge interval, the potential difference between the main and complementary main bit lines **MBL0** and **MBL1** can be eliminated before the read operation is started.

In this case, when the first and second column gate control signals **YG0** and **YG1** are asserted to the high level, the first and fourth select signals **TSG1** and **BSG1** are changed into the high level so that the first memory cell block **10a** including the memory cell **Ma0** selected is connected to the main bit line **MBL0** and that the fourth memory cell block **10d** including the dummy cell **DMd0** is connected to the complementary main bit line **MBL1**. It should be noted that the first and fourth select signals **TSG1** and **BSG1** may be asserted to the high level either at the same time with, or after, the assertion of the first and column gate control signals **YG0** and **YG1** to the high level.

Subsequently, just before the read interval starts, i.e., immediately before the word line **TWL0** connected to the memory cell **Ma0** selected is activated to the high level, the first and second equalize signals **EQ0** and **EQ1** are changed into the high level, thereby disconnecting the main and complementary main bit lines **MBL0** and **MBL1** from each other. At this time, the first pre-charge signal **PCN0** is negated to the high level, while the second pre-charge signal **PCN1** is kept asserted at the low level. Optionally, a read operation may also be performed even if the second pre-charge signal **PCN1**, as well as the first pre-charge signal **PCN0**, is negated to the high level.

Next, in the read interval, it is determined whether the charges that were stored on the main and complementary main bit lines **MBL0** and **MBL1** during the pre-charge interval have been discharged by the selected memory cell **Ma0** and a predetermined dummy cell.

In this embodiment, the memory cell **Ma0** to be accessed and the dummy cell **DMd0** in the fourth memory cell block **10d** are selected by activating the word line **TWL0** and dummy word line **BDWL0** to the high level. In this manner, this embodiment is characterized by selecting a dummy cell for supplying a reference potential to the sense amplifier **SA0** from the dummy cells **DMa0** through **DMd0** included in the first cell array unit **UNIT_A0**, to which the first memory cell block **10a** including the selected memory cell **Ma0** belongs. In other words, the dummy cell **DMd0** included in the fourth memory cell block **10d**, which is located near the first memory cell block **10a** and connected to the complementary main bit line **MBL1** and to the word lines different from those connected to the first memory cell block **10a**, is selected.

As described above, according to this embodiment, if the memory cell **Ma0** in the first memory cell block **10a** is selected during a read operation, the fourth select signal **BSG1** and the dummy word line **BDWL0** are activated to the high level to select the dummy cell **DMd0** included in the fourth memory cell block **10d** belonging to the first cell array unit **UNIT_A0** to which the first memory cell block **10a** belongs. As a result, the dummy cell **DMd0** closest to the memory cell **Ma0** to be accessed is selected from multiple selectable dummy cells. Accordingly, signal delay and superposition of noise components, which are easily caused during a read operation if a dummy cell selected is relatively distant from a memory cell selected, can be prevented.

As described above, the second through fourth cell array units **UNIT_B0**, **UNIT_C0** and **UNIT_D0** with the same configuration as the first cell array unit **UNIT_A0** are provided according to this embodiment. Even so, a memory cell and a dummy cell for supplying its reference potential are selected from each cell array unit during the read operation.

In general, an amplifier of the type sensing a read current like the sense amplifier **SA0** determines whether or not pre-charged bit lines have been discharged (i.e., whether their potentials have decreased) by the current flowing through a selected memory cell by comparing the memory cell and a selected dummy cell to each other. In this case, if the selected memory cell is being written, or in the "1" state, then the main bit line **MBL0** is discharged (i.e., the potential on the line drops) because a current path leading to the ground potential is formed. On the other hand, if the selected memory cell is being erased, or in the "0" state, then the potential is kept approximately equal to the pre-charge level because no current path is formed. The complementary main bit line **MBL1** connected to the dummy cell is also discharged (i.e., the potential on the line also drops) due to the cell current of the dummy cell. However, its waveform of discharge is defined just at the median between the waveform of discharge of the main bit line **MBL0** connected to a memory cell being erased and that of the main bit line **MBL0** connected to a memory cell being written.

Subsequently, after the potential difference between the main and complementary main bit lines **MBL0** and **MBL1** gets ready to be sensed by the sense amplifier **SA0**, the sense amplifier enable signal **SAE** and its inverted signal **SAEN** are asserted to the high and low levels, respectively, thereby enabling the sense amplifier **SA0**, amplifying the potential difference between the main and complementary main bit lines **MBL0** and **MBL1** and starting to read out the data. Next, when or after the sense amplifier enable signal **SAE** is asserted to the high level, the first and second column gate control signals **YG0** and **YG1** are negated to the low level, thereby turning the first and second column gates **Y0** and **Y1** OFF. In this manner, the sense amplifier **SA0** is disconnected from the main and complementary main bit lines **MBL0** and **MBL1**.

As described above, in this embodiment, the dummy cells **DMa0, DMb0, DMc0** and **DMd0**, which supply a reference potential to the sense amplifier **SA0** to determine the data on a selected memory cell when the data is read out from the memory cell, are provided for the first through fourth memory cell blocks **10a, 10b, 10c** and **10d**, respectively. And each of the memory cell blocks **10a** through **10d**, which are connected to the main or complementary main bit line **MBL0** or **MBL1**, has the same circuit configuration. Thus, a pair of memory blocks, which are selected for the main and complementary main bit lines **MBL0** and **MBL1** during a read operation, have the same configuration. As a result, the capacitive loads of the main and complementary main bit lines **MBL0** and **MBL1** can be substantially equalized with each other. Accordingly, if these memory cell blocks **10a** through **10d** have the same configuration, the capacitances of the dummy cells **DMa0**, **DMb0**, **DMc0** and **DMd0** are preferably substantially equal to each other.

The nonvolatile semiconductor memory device of this embodiment not only provides a dummy cell for each memory cell block in one cell array unit but also has the following two features.

Firstly, the dummy cells **DMa0** through **DMd0** are located around respective ends of the memory cell blocks **10a** through **10d** so as to face each other in the direction in which the main and complementary main bit lines **MBL0** and **MBL1** extend. Also, in this embodiment, the first and third select gates **TS1** and **BS0** are placed between the first and third memory cell blocks **10a** and **10c** and the second and fourth select gates **TS1** and **BS0** are placed between the second and fourth memory cell blocks **10b** and **10d**. Thus, the first dummy cell **DMa0**, for example, can be disposed adjacent to the first select gate **TS1** for controlling connection between the main bit line **MBL0** and the first memory cell block **10a** to which the first dummy cell **DMa0** itself belongs. The same placement is applicable to the other dummy cells **DMb0** through **DMd0**.

In this manner, the dummy cells **DMa0** through **DMd0** are placed around respective ends of the memory cell blocks **10a** through **10d** so as to face each other in the direction in which the main bit lines **MBL0** and **MBL1** extend. That is to say, since these dummy cells are formed to be adjacent to each other during the fabrication process of the device, the operating characteristics (e.g., threshold voltages) of the dummy cells are less likely variable in the fabrication process.

Also, the wire length between the memory cell selected and the sense amplifier **SA0** by way of the main bit line **MBL0** is not so different from the wire length between the dummy cell selected and the sense amplifier **SA0** by way of the complementary main bit line **MBL1**. For example, the memory cell **Ma0** is closer to the sense amplifier **SA0** than any other cell in the first memory cell block **10a** selected, but is connected to the main bit line **MBL0** via the first select gate **TS1** over the longest part of the sub-bit line **SBL0**. The fourth memory cell block **10d** selected is distant from the sense amplifier **SA0** because the second memory cell block **10b** is interposed therebetween. But the dummy cell **DMd0** is connected to the complementary main bit line **MBL1** via the fourth select gate. **BS1** over a shorter part of the sub-bit line **SBL3** than any other cell in the block. Thus, the wire length between the memory cell selected and the sense amplifier **SA0** or between the dummy cell selected and the sense amplifier **SA0** does not depend on its location, i.e., whether or not the cell is close to the sense amplifier **SA0**.

The first and third select gates **TS1** and **BS0**, connected to the main bit line **MBL0**, and the second and fourth select gates **TS0** and **BS1**, connected to the complementary main bit line **MBL1**, are provided between the memory cell blocks **10a** through **10d**. Thus, the distance between the memory cell selected and the sense amplifier **SA0** is not so different from the distance between the dummy cell selected and the sense amplifier **SA**. As a result, the signal delay and superposition of noise are much reduced.

Furthermore, the first through fourth select gates **TS1**, **TS0**, **BS0** and **BS1** are placed to be adjacent to each other between the memory cell blocks **10a** through **10d**. Accordingly, the same signal can be used as the first and fourth select gate signals **TSG1** and **BSG1** or as the second and third select gate signals **TSG0** and **BSG0** more easily. As a result, it is easier to synchronize, or to time the generation of, these signals. In addition, the area occupied by the associated signal lines can be reduced and the circuit configuration can be simplified.

Secondly, a pseudo-folded bit line arrangement, which is similar to, but different from, the known folded bit line arrangement, is adopted.

Hereinafter, the pseudo-folded bit line arrangement according to this embodiment will be described in detail.

First, a known bit line folding technique applicable to a DRAM device will be briefly described. A folded bit line arrangement for a DRAM is a wiring technique by which multiple word lines and bit lines are arranged to intersect with each other and an adjacent pair of bit lines, consisting of a bit line and a complementary bit line, are used as input lines for each sense amplifier. This bit line folding technique is advantageous in that particularly when a differential sense amplifier is used, the noise components superposed on the pair of bit lines are sensed as components in almost the same phases thanks to the symmetrical layout, and the sense amplifier can eliminate the noise components from its input signals much more satisfactorily.

In a DRAM in general, a memory cell consists of one capacitor and one switching transistor, and a memory cell connected to a bit line and another memory cell connected to a complementary bit line are not connected to the same word line. That is to say, since only one memory cell is activated per pair of bit lines, the bit line folding technique is realized.

However, the folded bit line arrangement for a DRAM is not applicable to a nonvolatile semiconductor memory device as it is. This is because if the arrangement in which multiple word and bit lines intersect with each other is used, a pair of memory cells, which are adjacent to each other between a pair of bit lines, are activated simultaneously per word line.

Thus, according to this embodiment, a pseudo-folded bit line arrangement with the following features is adopted:

(1) The main and complementary main bit lines are arranged by the bit line folding technique;
(2) Each cell array unit is divided into multiple memory cell blocks and a sub-bit line is provided for each of the memory cell blocks divided;
(3) A dummy cell for generating a reference potential is provided for the sub-bit line in each memory cell block and a select gate to be connected to a main or complementary main bit line is provided for each memory cell block; and
(4) When a memory cell is selected, a dummy cell, belonging to a memory cell block connected to a word line and a main bit line different from those of a memory cell block to which the selected memory cell belongs, is selected.

The pseudo-folded bit line arrangement according to this embodiment attains the following effects:

(a) Since the main and complementary main bit lines are arranged by the bit line folding technique, the immunity to the in-phase noise increases.

(b) A sub-bit line for each memory cell block can be shorter in wire length because the sub-bit line is placed by the opened bit line arrangement. In addition, a sub-bit line and another sub-bit line paired with the former sub-bit line, e.g., first and fourth sub-bit lines **SBL0** and **SBL1** or second and third sub-bit lines **SBL1** and **SBL2**, can be disposed closely to each other. Thus, these sub-bit lines are less affected by the noise to be differential inputs;

(c) As described for the first feature, an arrangement, making the wire length between a dummy cell selected and the sense amplifier not so different from the wire length between a memory cell selected and the sense amplifier, can be adopted. The difference is at most approximately equal to the length of a sub-bit line. Also, the difference in length between sub-bit lines is at most equal to twice the length of the sub-bit line.

(d) As also described for the first feature, the generation of control signals for controlling respective select gates can be timed easily.

By adopting such a pseudo-folded bit line arrangement, even a nonvolatile semiconductor memory device can attain noise immunity comparable to that of a DRAM with the folded bit line arrangement. As a result, the reference potential can be generated much more precisely, the sensitivity of the sense amplifier can be improved greatly and the read time can be shortened considerably.

In this embodiment, each of the dummy cells **DMa0** through **DMd0** is implemented as a single memory cell. Alternatively, each dummy cell may be a serial connection of two memory cells or the threshold voltage thereof may be adjusted so that the dummy cell current is approximately a median between the current flowing through a memory cell being written and the current flowing through a memory cell being erased. That is to say, the dummy cell may have any configuration so long as the dummy cell current generates the reference potential **Vref0** as indicated by the broken line in FIG. **9**. Accordingly, the dummy cell does not have to be implemented as a memory cell, but may be a serial connection of two n-channel MOS transistors.

EMBODIMENT 2

Hereinafter, a second embodiment of the present invention will be described with reference to the drawings.

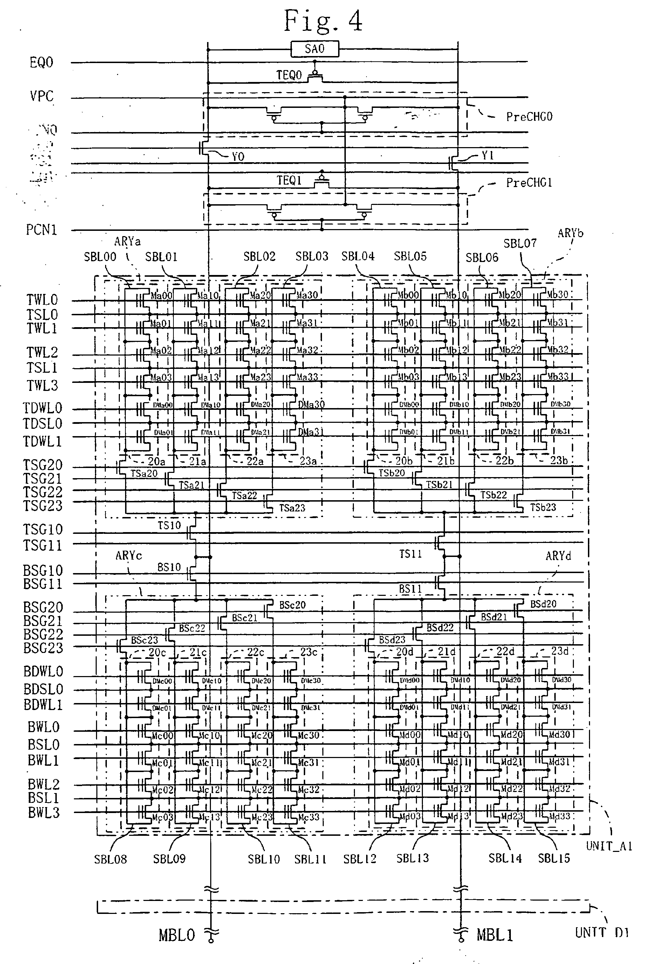

FIG. **4** illustrates a circuit configuration for a non-volatile semiconductor memory device according to the second embodiment of the present invention. The second embodiment is extension of the first embodiment. Thus, in FIG. **4**, the same components as those illustrated in FIG. **2** are identified by the same reference numerals and the description thereof will be omitted herein. As shown in FIG. **4,** in the nonvolatile semiconductor memory device according to this embodiment, a first cell array unit **UNIT_A1** includes: a first cell array **ARYa** including first through fourth memory cell blocks **20a** through **23a** that are connected in parallel to the main bit line **MBL0**; a second cell array **ARYb** including first through fourth memory cell blocks **20b** through **23b** that are connected in parallel to the complementary main bit line **MBL1;** a third cell array **ARYc** including first through fourth memory cell blocks **20c** through **23c** that are connected in parallel to the main bit line **MBL0**; and a fourth cell array **ARYd** including first through fourth memory cell blocks **20d** through **23d** that are connected in parallel to the complementary main bit line **MBL1**. Although not shown, each of the second through fourth cell array units **UNIT_B1** through **UNIT_D1** has the same configuration as the first cell array unit **UNIT_A1**.

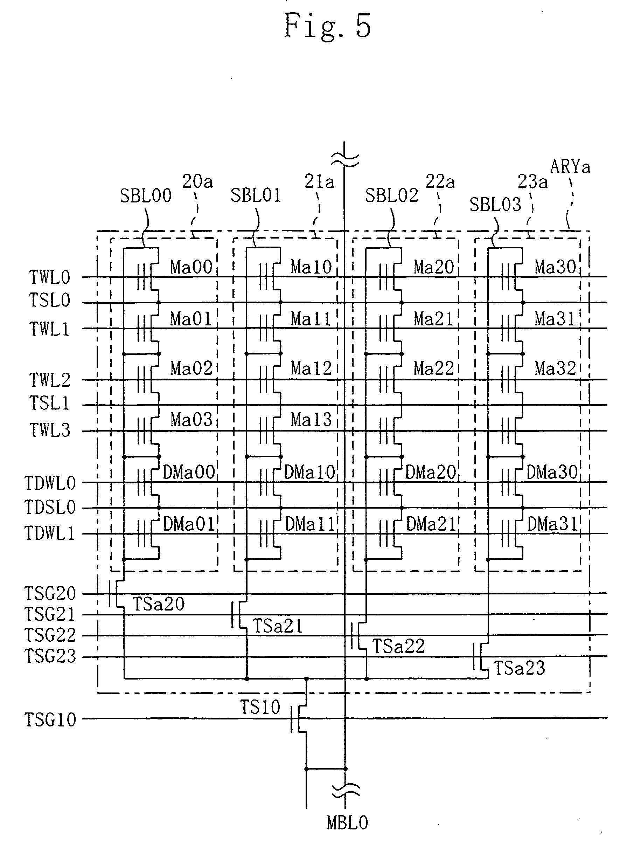

FIG. **5** illustrates a circuit configuration for the first cell array **ARYa**. As shown in FIG. **5**, the first memory cell block **20a** in the first cell array **ARYa** includes: four memory cells **Ma00** through **Ma03**, which are connected in series together and to word lines **TWL0** through **TWL3**, respectively; and dummy cells **DMa00** and **DMa01**, which are connected in series together and to dummy word lines **TDWL0** and **TDWL1**, respectively. The drains of the memory cells **Ma00** through **Ma03** and the dummy cells **DMa00** and **DMa01** are connected to the first select gate **TS10,** which receives a first select signal **TSG10** at its gate, through a first sub-bit line **SBL00** and first select transistor **TSa20**. The sources of the memory cells **Ma00** through **Ma03** are connected to source lines **TSL0** and **TSL1**, while the sources of the dummy cells **DMa00** and **DMa01** are connected to a dummy source line **TDSL0.**

In the same way, the second memory cell block **21a** includes: four memory cells **Ma10** through **Ma13**, which are connected in series together and to the word lines **TWL0** through **TWL3**, respectively; and dummy cells **DMa10** and **DMa11**, which are connected in series together and to the dummy word lines **TDWL0** and **TDWL1**, respectively. The drains of the memory cells **Ma10**, through **Ma13** and the dummy cells **DMa10** and **DMa11** are connected to the first select gate **TS10** through a second sub-bit line **SBL01** and second select transistor **TSa21**. The sources of the memory cells **Ma10** through **Ma13** are connected to the source lines **TSL0** and **TSL1**, while the sources of the dummy cells **DMa10** and **DMa11** are connected to the dummy source line **TDSL0**. The third and fourth memory cell blocks **22a** and **23a** also has the same configuration as the first and second memory cell blocks **20a** and **21a** and the description thereof will be omitted herein.

The first select transistor **TSa20**, which selectively connects the first select gate **TS10** to the first memory cell block **20a,** receives a first in-array select signal **TSG20**. In the same way, the second through fourth select transistors **TSa21** through **TSa23**, which selectively connect the first select gate **TS10** to the second through fourth memory cell blocks **21a** through **23a**, receive second through fourth in-array select signals **TSG21** through **TSG23**, respectively.

Also, as shown in FIG. **4**, each of the second through fourth cell arrays **ARYb** through **ARYd** has the same circuit configuration as the first cell array **ARYa**. Moreover, the dummy cells **DMa00** through **DMa31** in the respective memory cell blocks **20a** through **23a** of the first cell array **ARYa** and the dummy cells **DMc00** through **DMc31** in the respective memory cell blocks **20c** through **23c** of the third cell array **ARYc** are placed around respective ends to face each other in the direction in which the main bit line **MBL0** extends. In the same way, the dummy cells **DMb00** through **DMb31** of the second cell array **ARYb** and the dummy cells **DMd00** through **DMd31** of the fourth cell array **ARYd** are also placed around respective ends to face each other in the direction in which the complementary main bit line **MBL1** extends.

Hereinafter, it will be described with reference to the timing chart how the nonvolatile semiconductor memory device with such a configuration operates.

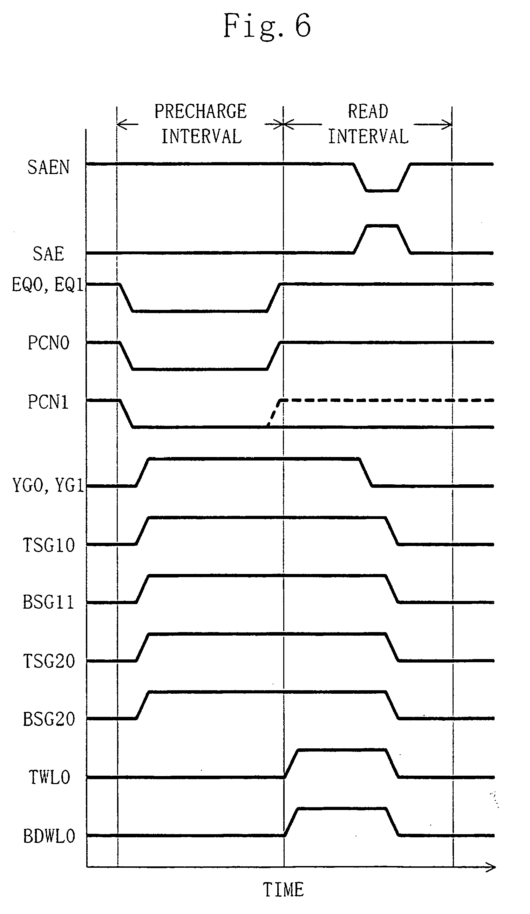

FIG. **6** illustrates a timing chart showing a read operation performed by the nonvolatile semiconductor memory device according to this embodiment. In the illustrated example, a read operation on the memory cell **Ma00** in the first memory cell block **20a** of the first cell array **ARYa** connected to the main bit line **MBL0** as shown in FIG. **4** will be described.

First, structural difference between this and first embodiments will be described. In the semiconductor memory device according to the first embodiment shown in FIG. **2**, if the word line **TWL0** has been activated, for example, the two memory cells **Ma0** and **Mb0** are activated at the same time. In the semiconductor memory device according to this embodiment on the other hand, if the word line **TWL0** has been activated, the four memory cells **Ma00** through **Ma30** are activated at the same time as shown in FIG. **5**. The same statement is also applicable to the dummy cells.

Furthermore, in the semiconductor memory device according to this embodiment, two dummy word lines are provided per cell block, e.g., the first cell array **ARYa**. Specifically, the dummy word line **TDWL0**, which is disposed on an even-numbered row and connected to the four dummy cells **DMa00** through **DMa30**, and the dummy word line **TDWL1**, which is disposed on an odd-numbered row and connected to the four dummy cells **DMa01** through **DMa31** are provided. It should be noted that a word line is identified as "even-numbered" or "odd-numbered" by the subscript attached to the end thereof. As can be seen, the memory and dummy cells are arranged differently between this and first embodiments. Thus, the following description of this embodiment will be focused on how a dummy cell for supplying a reference potential for readout to the sense amplifier **SA0** is selected in performing a read operation on the memory cell **Ma00**. In this embodiment, the procedure of selecting an appropriate dummy cell will be called "narrowing".

First, when a READ instruction that the memory cell **Ma00** belonging to the first memory cell block **20a** of the first cell array **ARYa** in the first cell array unit **UNIT_A1** should be accessed is externally input, a pre-charge interval shown in FIG. **6** starts, when the first and second pre-charge signals **PCN0** and **PCN1** are changed from the high into low level with the word lines **TWL0** through **TWL3** and **BWL0** through **BWL3**, dummy word lines **TDWL0**, **TDWL1**, **BDWL0** and **BDWL1** and first through fourth select signals **TSG10**, **TSG11, BSG10** and **BSG11** shown in FIG. **4** all kept deactivated (i.e., low). At the same time, the first and second equalize signals **EQ0** and **EQ1** are changed into the low level, thereby turning the first and second equalize transistors **TEQ0** and **TEQ1** ON.

Next, the first and second column gate control signals **YG0** and **YG1**, which connect the main and complementary main bit lines **MBL0** and **MBL1** to the sense amplifier **SA0**, are changed into the high level to turn the column gates **Y0** and **Y1** ON. In this manner, the input and output terminals of the sense amplifier **SA0** are also pre-charged to the same potential level as the main bit line **MBL0**.

At the same time, the first select signal **TSG10** is asserted to the high level so that the first cell array **ARYa** including the first memory cell block **20a** selected is connected to the main bit line **MBL0**. Simultaneously, the first in-array select signal **TSG20** is also asserted to the high level so that the memory cell **Ma00** selected is connected to the first select gate **TS10**. In this example, a dummy cell is selected from the fourth cell array **ARYd**. Thus, the fourth select signal **BSG11** is asserted to the high level so that the fourth cell array **ARYd** is connected to the complementary main bit line **MBL1**. At the same time, the first in-array select signal **BSG20** is also asserted to the high level.

In the succeeding read interval, the same operations are performed as in the first embodiment.

Hereinafter, a procedure through which the first in-array select signal **BSG20** is selectively asserted will be described.

*First narrowing process step*

First, the fourth cell array **ARYd**, connected to the complementary main bit line **MBL1** and to word lines different from those of the first cell array **ARYa**, is selected from the other cell arrays located close to the first cell array **ARYa**, i.e., cell arrays belonging to the first cell array unit **UNIT_A1**. As a result, the selectable candidates are narrowed down to the eight dummy cells **DMd00** through **DMd31** included in the first through fourth memory cell blocks **20d** through **23d** belonging to the fourth cell array **ARYd**.

*Second narrowing process step*

Next, the eight candidate dummy cells **DMd00** through **DMd31** are further narrowed down by finding such dummy cells as minimizing the difference between the wire length from the first memory cell block **20a** selected to the main bit line **MBL0** and the wire length from a memory cell block including the candidate dummy cell to the complementary main bit line **MBL1**. In this example, the first memory cell block **20a** selected is not adjacent to the main bit line **MBL0**. Thus, the candidates are narrowed down to the dummy cells **DMd00, DMD01**, **DMd30** and **DMD31** included in the first and fourth memory cell blocks **20d** and **23d** of the fourth cell array **ARYd** that are not adjacent to the complementary main bit line **MBL1**.

As a result of this process step, the total wire length of parts of the main bit line **MBL0** and the first sub-bit line **SBL00** that should be passed to access the memory cell **Ma00** selected is not so different during reading from the total wire length of parts of the complementary main bit line **MBL1** and the first or fourth sub-bit line **SBL12** or **SBL15** that should be passed to access the candidate dummy cell **DMd00**, **DMD01**, **DMd30** or **DMD31**. Thus, the coupling capacitance formed between the main bit line **MBL0** and the sub-bit line **SBL00** can be substantially equal to the coupling capacitance formed between the complementary main bit line **MBL1** and the sub-bit line **SBL12** or **SBL15**. As a result, variation in line capacitance between the main and complementary main bit lines **MBL0** and **MBL1** can be reduced during reading.

*Third narrowing process step*

The third narrowing process step is effectively applicable to a situation where multiple dummy word lines are provided for a single cell array. That is to say, difference in characteristics of memory and dummy cells, which is caused depending on whether each of the word lines is disposed on an even- or odd-numbered row during the fabrication of this semiconductor memory device, can be suppressed.

More specifically, the memory cell **Ma00** to be accessed is connected to the even-numbered word line **TWL0**. Thus, the candidate dummy cells **DMd00**, **DMD01**, **DMd30** and **DMD31**, which still remain after the second narrowing process step, are narrowed down to the two dummy cells **DMd00** and **DMd30** that are connected to the even-numbered dummy word line **BDWL0** in the fourth cell array **ARYd**. This selection corresponds to the example illustrated in FIG. **6**, in which the word line **TWL0** and the dummy word line **BDWL0** are activated to the high level simultaneously during the read interval. Alternatively, if the memory cell to be accessed is connected to an odd-numbered word line, e.g., the word line **TWL1**, then the candidates are narrowed down to the two dummy cells **DMd01** and **DMd31** that are connected to the odd-numbered dummy word line **BDWL1** in the fourth cell array **ARYd**.

Next, one dummy cell is arbitrarily selected from the two remaining, candidate dummy cells **DMd00** and **DMd30.** In this example, the dummy cell **DMd30** belonging to the fourth memory cell block **23d** is selected.

It should be noted that the first through third narrowing process steps just indicate a design procedure sequentially. Thus, these process steps are not performed every time the semiconductor memory device actually performs a read operation. That is to say, this procedure is pre-programmed so that a unique dummy cell can be selected at the same time with address encoding and decoding at respective memory cells.

As described above, the same effects as those of the first embodiment are attainable by this embodiment, too. In addition, even if characteristics of memory cells that were formed adjacently on even- and odd-numbered rows are different from each other due to fabrication process conditions, e.g., doping conditions for a semiconductor substrate, the cell characteristics can be matched between memory and dummy cells selected.

If these cell arrays **ARYa** through **ARYd** have the same configuration, the capacitance formed between each pair of dummy cells is preferably substantially equal.

In this embodiment, four memory cells are connected in parallel to the main or complementary main bit line **MBL0** or **MBL1** and activated through a single word line. Alternatively, any other appropriate number may be selected in view of storage capacity and specifications.

Although the application has not been stated explicitly, the present invention is particularly effectively applicable to various memory integrated circuits like EEPROM or flash EEPROM device including a differential sense amplifier or to an integrated circuit unit, such as a microcomputer, including any of these memory integrated circuits.

**Claims**

**1.**   A nonvolatile semiconductor memory device comprising:

first and second word lines (TWL0, BDWL0),
first and second bit lines (BL0, BL1), each intersecting with both of the first and second word lines;

first and second memory cell blocks (10a, 10b), each including at least one memory cell connected to the first word line;

third and fourth memory cell blocks (10c, 10d), each including at least one memory cell connected to the second word line (BDWL0),

first connection means (7) for connecting the first bit line (BL0) to the first memory cell block (10a) responsive to a first control signal;

second connection means (8) for connecting the second bit line (BL1) to the second memory cell block (10b) responsive to a second control signal;

third connection means for connecting the first bit line to the third memory cell block (10c) responsive to a third control signal;

fourth connection means for connecting the second bit line to the fourth memory cell block (10d) responsive to a fourth control signal; and

an amplifier (SAE) for performing input/output operations on the first and second bit lines (BLO, BL1),

characterized in that each said memory cell block (10a, 10b, 10c, 10d) includes at least one dummy cell (3, 5).

2. A nonvolatile semiconductor memory device as recited in claim 1, **characterized in that** the memory cell blocks (10a, 10b, 10c, 10d) are provided to have an equal capacitance.

3. A nonvolatile semiconductor memory device as recited in claim 1, **characterized in that** a capacitive load, which is added to the amplifier (SAE) by the first bit line(BL0) and the first or third memory cell block (10a, 10c) connected to the first bit line, is substantially equal to a capacitive load, which is added to the amplifier (SAE) by the second bit line (BL1) and the second or fourth memory cell block (10b, 10d) connected to the second bit line (BL1).

4. A nonvolatile semiconductor memory device as recited in claim 1, **characterized in that** in reading out data from one of the memory cells connected to the first bit line (BL0) to the amplifier (SAE), one of the dummy cells (3, 5), which is included in one of the memory cell blocks (10a, 10b, 10c, 10d) that is located near the memory cell block including the memory cell being accessed and that is connected to the second bit line (BL1), is selected.

5. A nonvolatile semiconductor memory device as recited in claim 1, **characterized in that** in reading out data from one of the memory cells connected to the first bit line (BL0) to the amplifier by activating the first or second word line (TWL0, BDWL0), one of the dummy cells, which is included in one of the memory cell blocks that is connected to one of the word lines, to which the memory cell being accessed is not connected, and to the second bit line, is selected.

6. A nonvolatile semiconductor memory device as recited in claim 1, further comprising multiple cell array units (UNIT-A0), each including the first, second and third and fourth memory cell blocks(10a, 10b, 10c, 10d),

**characterized in that** in reading out data from one of the memory cells connected to the first bit line (BL0) in one of the cell array units to the amplifier (SAE) by activating the first or second word line (TWL0, BDWL0),

one of the dummy cells(3, 5), which is included in one of the memory cell blocks that is connected to one of the word lines, to which the memory cell being accessed is not connected, and to the second bit line in the cell array unit, is selected.

7. A nonvolatile semiconductor memory device as recited in claim 6, **characterized in that** each said memory cell block (10a, 10b, 10c, 10d) comprises multiple dummy cells(3, 5), and

that when one of the dummy cells(3, 5) is selected, a wire length between the dummy cell (3, 5) selected and the second bit line (BL1) is substantially equal to a wire length between the first bit line (BL0) and the memory cell being accessed and connected to the first bit line (BL0).

8. A nonvolatile semiconductor memory device as recited in claim 6, **characterized in that** each said memory cell block (10a, 10b, 10c, 10d) comprises multiple dummy cells(3, 5), and

that one of the dummy cells, which is located closest to the memory cell being accessed and connected to the first bit line (BL0), is selected.

9. A nonvolatile semiconductor memory device as recited in claim 1, **characterized in that** each said memory cell block (10a, 10b, 10c, 10d) comprises: a first dummy cell connected to an odd-numbered one of the word lines; and a second dummy cell connected to an even-numbered one of the word lines, and

that the first dummy cell is selected in selecting one of the memory cells connected to an odd-numbered one of the word lines (TWL0, BDWL0), while the second dummy cell is selected in selecting one of the memory cells connected to an even-numbered one of the word lines.

10. A nonvolatile semiconductor memory device as recited in claim 1, **characterized in that** the dummy cells are located around respective ends of the memory cell blocks so as to face each other in a direction in which the bit lines extend.

11. A nonvolatile semiconductor memory device as recited in claim 1, **characterized in that** the first control signal is the same as the fourth control signal and the second control signal is the same as the third control signal.

**Patentansprüche**

1. Nicht-flüchtige Halbleiterspeichervorrichtung, die umfasst:

eine erste und eine zweite Wortleitung (TWL0, BDWL0),
eine erste und eine zweite Bitleitung (BLO, BL1), die jeweils sowohl die erste als auch die zweite Wortleitung kreuzen;
einen ersten und einen zweiten Speicherzellenblock (10a, 10b), die jeweils wenigstens eine Speicherzelle enthalten, die mit der ersten Wortleitung verbunden ist;
einen dritten und einen vierten Speicherzellenblock (10c, 10d), die jeweils wenigstens eine Speicherzelle enthalten, die mit der zweiten Wortleitung (BDWL0) verbunden ist,
eine erste Verbindungseinrichtung (7) zum Verbinden der ersten Bitleitung (BL0) mit dem ersten Speicherzellenblock (10a) in Reaktion auf ein erstes Steuersignal;
eine zweite Verbindungseinrichtung (8) zum Verbinden der zweiten Bitleitung (BL1) mit dem zweiten Speicherzellenblock (10b) in Reaktion auf ein zweites Steuersignal;
eine dritte Verbindungseinrichtung zum Verbinden der ersten Bitleitung mit dem dritten Speicherzellenblock (10c) in Reaktion auf ein drittes Steuersignal;
eine vierte Verbindungseinrichtung zum Verbinden der zweiten Bitleitung mit dem vierten Speicherzellenblock (10d) in Reaktion auf ein viertes Steuersignal; und
einen Verstärker (SEA) zum Durchführen von Eingabe/Ausgabeoperationen auf der ersten und der zweiten Bitleitung (BLO, BL1),

**dadurch gekennzeichnet, dass** jeder Speicherzellenblock (10a, 10b, 10c, 10d) wenigstens eine Leerzelle (3, 5) enthält.

2. Nicht-flüchtige Halbleiterspeichervorrichtung nach Anspruch 1, **dadurch gekennzeichnet, dass** die Speicherzellenblöcke (10a, 10b, 10c, 10d) mit gleicher Kapazität vorhanden sind.

3. Nicht-flüchtige Halbleiterspeichervorrichtung nach Anspruch 1, **dadurch gekennzeichnet, dass** eine kapazitive Last, die zu dem Verstärker (SAE) durch die erste Bitleitung (BL0) und den ersten oder den dritten Speicherzellenblock (10a, 10c), der mit der ersten Bitleitung verbunden ist, hinzugefügt wird, im Wesentlichen einer kapazitiven Last gleich ist, die zu dem Verstärker (SAE) durch die zweite Bitleitung (BL1) und den zweiten oder den vierten Speicherzellenblock (10b, 10d), der mit der zweiten Bitleitung (BL1) verbunden ist, hinzugefügt wird.

4. Nicht-flüchtige Halbleiterspeichervorrichtung nach Anspruch 1, **dadurch gekennzeichnet, dass** beim Auslesen von Daten aus einer der Speicherzellen, die mit der ersten Bitleitung (BL0) verbunden ist, in den Verstärker (SAE) eine der Leerzellen (3, 5) ausgewählt wird, die in einem der Speicherzellenblöcke (10a, 10b, 10c, 10d) enthalten ist, der sich nahe an dem Speicherzellenblock befindet, der die Speicherzelle enthält, auf die zugegriffen wird und der mit der zweiten Bitleitung (BL1) verbunden ist.

5. Nicht-flüchtige Halbleiterspeichervorrichtung nach Anspruch 1, **dadurch gekennzeichnet, dass** beim Auslesen von Daten aus einer der Speicherzellen, die mit der ersten Bitleitung (BL0) verbunden ist, in den Verstärker durch Aktivieren der ersten oder zweiten Wortleitung (TWL0, BDWL0) eine der Leerzellen ausgewählt wird, die in einem der Speicherzellenblöcke enthalten ist, der mit einer der Wortleitungen, mit der die Speicherzelle, auf die zugegriffen wird, nicht verbunden ist, und mit der zweiten Bitleitung verbunden ist.

6. Nicht-flüchtige Halbleiterspeichervorrichtung nach Anspruch 1, die des Weiteren mehrere Zellengruppeneinheiten (UNIT-A0) umfasst, die jeweils den ersten, den zweiten, und den dritten sowie den vierten Speicherzellenblock (10a, 10b, 10c, 10d) enthalten,

**dadurch gekennzeichnet, dass** beim Auslesen von Daten aus einer der Speicherzellen, die mit der ersten Bitleitung (BL0) verbunden ist, in einer der Zellengruppeneinheiten in dem Verstärker (SAE) durch Aktivieren der ersten oder der zweiten Wortleitung (TWL0, BDWL0),

eine der Leerzellen (3, 5) ausgewählt wird, die in einem der Speicherzellenblöcke enthalten ist und der mit einer der Wortleitungen, mit der die Speicherzelle, auf die zugegriffen wird, nicht verbunden ist, sowie mit der zweiten Bitleitung in der Zellengruppenanordnung verbunden ist.

7. Nicht-flüchtige Halbleiterspeichervorrichtung nach Anspruch 6, **dadurch gekennzeichnet, dass** jeder Speicherzellenblock (10a, 10b, 10c, 10d) mehrere Leerzellen (3, 5) enthält, und

dass, wenn eine der Leerzellen (3, 5) ausgewählt wird, eine Drahtlänge zwischen der ausgewählten Leerzelle (3, 5) und der zweiten Bitleitung (BL1) im Wesentlichen einer Drahtlänge zwischen der ersten Bitleitung (BL0) und der Speicherzelle gleich ist, auf die zugegriffen wird und die mit der ersten Bitleitung (BL0) verbunden ist.

8. Nicht-flüchtige Halbleiterspeichervorrichtung nach Anspruch 6, **dadurch gekennzeichnet, dass** jeder Speicherzellenblock (10a, 10b, 10c, 10d) mehrere Leerzellen (3, 5) umfasst, und

dass eine der Leerzellen, die sich am nächsten an der Speicherzelle befindet, auf die zugegriffen wird und die mit der ersten Bitleitung (BL0) verbunden ist, ausgewählt wird.

9. Nicht-flüchtige Halbleiterspeichervorrichtung nach Anspruch 1, **dadurch gekennzeichnet, dass** jeder Speicherzellenblock (10a, 10b, 10c, 10d) umfasst:

eine erste Leerzelle, die mit einer ungeradzahligen der Wortleitungen verbunden ist; und
eine zweite Leerzelle, die mit einer geradzahligen der Wortleitungen verbunden ist, und

dass die erste Leerzelle ausgewählt wird, wenn eine der Speicherzellen ausgewählt wird, die mit einer ungeradzahligen der Wortleitungen (TWL0, BDWL0) verbunden ist, während die zweite Leerzelle ausgewählt wird, wenn eine der Speicherzellen ausgewählt wird, die mit einer geradzahligen der Wortleitungen verbunden ist.

10. Nicht-flüchtige Halbleiterspeichervorrichtung nach Anspruch 1, **dadurch gekennzeichnet, dass** die Leerzellen um jeweilige Enden der Speicherzellenblöcke herum so angeordnet sind, dass sie einander in einer Richtung zugewandt sind, in der sich die Bitleitungen erstrecken.

11. Nicht-flüchtige Halbleiterspeichervorrichtung nach Anspruch 1, **dadurch gekennzeichnet, dass** das erste Steuersignal das gleiche ist wie das vierte Steuersignal und das zweite Steuersignal das gleiche ist wie das dritte Steuersignal.

## Revendications

1. Dispositif de mémoire non volatile à semi-conducteurs comprenant :

des première et deuxième lignes de mots (TWL0, BDWL0),
des première et deuxième lignes de bits (BL0, BL1), chacune se croisant avec à la fois la première et la deuxième lignes de mots ;
des premier et deuxième blocs de cellules de mémoire (10a, 10b), incluant chacun au moins une cellule de mémoire connectée à la première ligne de mots ;
des troisième et quatrième blocs de cellules de mémoire (10c, 10d), incluant chacun au moins une cellule de mémoire connectée à la deuxième ligne de mots (BDWL0),
un premier moyen de connexion (7) pour connecter la première ligne de bits (BL0) au premier bloc de cellules de mémoire (10a) sensible à un premier signal de commande ;
un deuxième moyen de connexion (8) pour connecter la deuxième ligne de bits (BL1) au deuxième bloc de cellules de mémoire (10b) sensible à un deuxième signal de commande ;
un troisième moyen de connexion pour connecter la première ligne de bits au troisième bloc de cellules de mémoire (10c) sensible à un troisième signal de commande ;
un quatrième moyen de connexion pour connecter la deuxième ligne de bits au quatrième bloc de cellules de mémoire (10d) sensible à un quatrième signal de commande ; et
un amplificateur (SAE) pour effectuer des opérations d'entrée/sortie sur les première et deuxième lignes de bits (BL0, BL1),

**caractérisé en ce que** chaque dit bloc de cellules de mémoire (10a, 10b, 10c, 10d) inclut au moins une cellule factice (3, 5).

2. Dispositif de mémoire non volatile à semi-conducteurs selon la revendication 1, **caractérisé en ce que** les blocs de cellules de mémoire (10a, 10b, 10c, 10d) sont pourvus de sorte à avoir une capacité égale.

3. Dispositif de mémoire non volatile à semi-conducteurs selon la revendication 1, **caractérisé en ce que** une charge capacitive, qui est ajoutée à l'amplificateur (SAE) par la première ligne de bits (BL0) et le premier ou troisième bloc de cellules de mémoire (10a, 10c) connecté à la première ligne de bits, est substantiellement égale à une charge capacitive, qui est ajoutée à l'amplificateur (SAE) par la deuxième ligne de bits (BL1) et le deuxième ou quatrième bloc de cellules de mémoire (IOb, 10d) connecté à la deuxième ligne de bites (BL1).

4. Dispositif de mémoire non volatile à semi-conducteurs selon la revendication 1, **caractérisé en ce que** lors d'une lecture de données depuis l'une des cellules de mémoire connectée à la première ligne de bits (BL0) à l'amplificateur (SAE), l'une des cellules factices (3, 5), qui est incluse dans l'un des blocs de cellules de mémoire (10a, 10b, 10c, 10d) qui est situé près du bloc de cellules de mémoire incluant la cellule de mémoire qui fait l'objet d'un accès et qui est connectée à la deuxième ligne de bits (BL1), est sélectionnée.

5. Dispositif de mémoire non volatile à semi-conducteurs selon la revendication 1, **caractérisé en ce que** lors d'une lecture de données depuis l'une des cellules de mémoire connectée à la première ligne de bits (BL0) à l'amplificateur en activant la première ou deuxième ligne de mots (TWL0, BDWL0), l'une des cellules factices, qui est incluse dans l'un des blocs de cellules de mémoire qui est connecté à l'une des lignes de mots, à laquelle la cellule de mémoire qui fait l'objet d'un accès n'est pas connectée, et à la deuxième ligne de bits, est sélectionnée.

6. Dispositif de mémoire non volatile à semi-conducteurs selon la revendication 1, comprenant en plus des unités de matrices de cellules multiples (UNIT-A0), chacune incluant les premier, deuxième et troisième et quatrième blocs de cellules de mémoire (10a, 10b, 10c, 10d).
   **caractérisé en ce que** en lisant des données depuis l'une des cellules de mémoire connectée à la première ligne de bits (BL0) dans l'une des unités de matrices de cellules à l'amplificateur (SAE) en activant la première ou deuxième lignes de mots (TWL0, BDWL0),
   l'une des cellules factices (3, 5), qui est incluse dans l'un des blocs de cellules de mémoire qui est connecté à l'une des lignes de mots, à laquelle la cellule de mémoire qui fait l'objet d'un accès n'est pas connectée, et à la deuxième ligne de bits dans l'unité de matrice de cellules, est sélectionnée.

7. Dispositif de mémoire non volatile à semi-conducteurs selon la revendication 6, **caractérisé en ce que** chaque dit bloc de cellules de mémoire (10a, 10b, 10c, 10d) comprend des cellules factices multiples (3, 5), et que lorsque l'une des cellules factices (3, 5) est sélectionnée, une longueur de fil entre la cellule factice (3, 5) sélectionnée et la deuxième ligne de bits (BL1) est substantiellement égale à une longueur de fil entre la première ligne de bits (BL0) et la cellule de mémoire qui fait l'objet d'un accès et connectée à la première ligne de bits (BL0).

8. Dispositif de mémoire non volatile à semi-conducteurs selon la revendication 6, **caractérisé en ce que** chaque dit bloc de cellules de mémoire (10a, 10b, 10c, 10d) comprend des cellules factices multiples (3, 5), et que l'une des cellules factices, qui est située le plus près de la cellule de mémoire qui fait l'objet d'un accès et connectée à la première ligne de bits (BL0), est sélectionnée.

9. Dispositif de mémoire non volatile à semi-conducteurs selon la revendication 1, **caractérisé en ce que** chaque dit bloc de cellules de mémoire (10a, 10b, 10c, 10d) comprend : une première cellule factice connectée à l'une à numéro impair des lignes de mots; et une deuxième cellule factice connectée à l'une à numéro pair des lignes de mots, et que la première cellule factice est sélectionnée en sélectionnant l'une des cellules de mémoire connectée à l'une à numéro impair des lignes de mots (TWL0, BDWL0), tandis que la deuxième cellule factice est sélectionnée en sélectionnant l'une des cellules de mémoire connectée à l'une à numéro paire des lignes de mots.

10. Dispositif de mémoire non volatile à semi-conducteurs selon la revendication 1, **caractérisé en ce que** les cellules factices sont situées autour d'extrémités respectives des blocs de cellules de mémoire de manière à être les unes en face des autres dans une direction dans laquelle les lignes de bits s'étendent.

11. Dispositif de mémoire non volatile à semi-conducteurs selon la revendication 1, **caractérisé en ce que** le premier signal de commande est le même que le quatrième signal de commande et le deuxième signal de commande et le même que le troisième signal de commande.

# Fig. 1

# Fig. 2

# Fig. 3

# Fig. 4

# Fig. 5

# Fig. 6

# Fig. 7

# Fig. 8

# Fig. 9

BIT LINE POTENTIAL

VPC
(1/2VDD)

"0"

$V_{ref1}$

$V_{ref2}$

$V_{ref0}$

"1"

0

TIME